# EUROPÄISCHE PATENTSCHRIFT

(11) **EP 1 691 481 B1**
(45) Veröffentlichungstag und Bekanntmachung des Hinweises auf die Patenterteilung: **02.04.2014**
(21) Anmeldenummer: 05003011.3
(22) Anmeldetag: 12.02.2005
(51) Int. Cl.: H03C 1/36

(54) **Amplitudenmodulator**
Amplitude modulator
Modulateur en amplitude

(43) Veröffentlichungstag der Anmeldung: 16.08.2006
(73) Patentinhaber: TRUMPF Hüttinger GmbH + Co. KG, 79111 Freiburg im Breisgau (DE)
(72) Erfinder: Kirchmeier, Thomas, 79331 Teningen (DE)
(74) Vertreter: Kohler Schmid Möbus

(56) Entgegenhaltungen:
- EP-A- 1 248 353
- EP-A- 1 411 694
- WO-A-02/03541
- US-A- 5 239 275
- US-B1- 6 194 978

## Beschreibung

Die Erfindung betrifft ein Verfahren zur Beeinflussung der Signalform eines Ausgangssignals eines HF-Leistungsresonanzverstärkers, bei dem ein Grundsignal einer Grundfrequenz verstärkt und mit einem Modulationssignal moduliert, insbesondere gepulst, wird, wobei ein Ausgangsschwingkreis des HF-Leistungsresonanzverstärkers auf eine Frequenz im Bereich der Grundfrequenz abgestimmt wird und im Normalbetrieb mit dem Grundsignal angeregt wird, sowie eine HF-Anregungsanordnung. Häufig wird der Ausgangsschwingkreis nicht genau auf die Grundfrequenz abgestimmt, um ein verlustarmes Schalten eines oder mehrerer schaltender Elemente des HF-Leistungsresonanzverstärkers zu ermöglichen.

Bei HF-Leistungsgeneratoren, die im Pulsbetrieb arbeiten, ist im Allgemeinen die Einschaltflanke der HF-Leistung, d.h. die Flanke der Einhüllenden des Ausgangssignals des HF-Leistungsgenerators, ein wichtiges Kriterium. Es gibt jedoch auch Anwendungen mit der vorrangigen Forderung nach schnellstmöglichem Abbruch der Pulse. Ein Beispiel ist der Betrieb von opto-akustischen Güteschaltern in gepulsten Beschriftungslasern. Hier soll zum Beispiel die 27MHz HF-Leistung des HF-Leistungsgenerators am Pulsende innerhalb von maximal 100ns, also 2,5 Schwingungsperioden von 50W auf weniger als 50mW abfallen. Problematisch bei der Verwendung eines Resonanzverstärkers ist, dass zwei Qualitätsmerkmale von der Güte des Ausgangsschwingkreises abhängen. Mit steigender Güte nimmt zwar die spektrale Reinheit des Ausgangssignals zu, ebenso steigt jedoch die Dauer des Ausschwingens beim Abschalten.

Aus der DE 199 29 332 A1 ist ein Treiber für einen Güteschalter oder andere akusto-optische Komponenten für Laseranwendungen bekannt geworden, mit einem Hochfrequenz-Oszillator und einem mit dem Signal des Hochfrequenz-Oszillators gespeisten Verstärker zum Treiben der akusto-optischen Komponente, der eine Bandbreite hat, die die Frequenz des Hochfrequenz-Oszillators um ein Mehrfaches übersteigt, und einen Steuereingang zum Einstellen der Verstärkung des Verstärkers aufweist, um die Beeinflussung eines Laserstrahls durch die akusto-optische Komponente zu steuern. Dieser Lösungsansatz benötigt also einen sehr breitbandigen Verstärker, der die in steilen Signalflanken enthaltenen höheren Frequenzanteile noch ausreichend beherrscht. Die Transistoren dieses Treibers müssen bei einer Frequenz betreibbar sein, die deutlich über der des HF-Signals liegt.

Aus der EP 1 411 694 A2 ist es bekannt, eine Trägerwelle einer vorbestimmten Frequenz mit einem Datensignal zu modulieren und über eine Antenneneinrichtung auszugeben.

Aus der US 6,194,978 B1 ist ein Verfahren zur Übertragung digitaler Information mitteils eines analogen Trägers bekannt. Das Verfahren beinhaltet das Unterbrechen des analogen Trägers, sodass das Fehlen des Trägers direkt mit der zu übertragenden digitalen Information korrespondiert.

In der EP 1 248 353 A2 ist ein Verfahren zur Steuerung des Ausgangs eines Generators beschrieben. Der Ausgang liefert ein Ausgangssignal, das eine Eingangsschwingzeit hat. Die Einschwingzeit des Ausgangssignals wird bestimmt. Das Ausgangssignal wird amplitudenmoduliert. Ein Detektionssignal wird generiert, das das modulierte Ausgangssignal beschreibt. Das Detektionssignal wird abgetastet und eine digitale Darstellung des abgetasteten Signals wird generiert. Die Amplitudenmodulation des Ausgangs wird basierend auf der digitalen Darstellung des abgetasteten Detektionssignals gesteuert.

Aufgabe der vorliegenden Erfindung ist es, ein Verfahren und eine Vorrichtung bereitzustellen, mit denen auf einfache Art und Weise steilflankige Ausgangssignale eines gepulsten HF-Leistungsverstärkers erzeugt werden können.

Diese Aufgabe wird erfindungsgemäß durch ein Verfahren mit den Merkmalen des Anspruchs 1 gelöst. Das vom Grundsignal abweichende Ansteuersignal wird im Folgenden Ansteuersignal genannt. Das Ansteuersignal kann insbesondere in der Phasenlage und/oder der Frequenz und/oder dem Tastverhältnis abweichen. Vorzugsweise beträgt die Abweichung wenigstens einer der Größen mindestens 5% von der entsprechenden Größe des Grundsignals im Normalbetrieb. Mit Normalbetrieb ist der Betrieb mit der Grundfrequenz ohne Generierung eines Ansteuersignals gemeint.

Durch diese Maßnahmen kann ein schnelleres als das natürliche exponentielle An - und Ausschwingen des Ausgangsschwingkreises erreicht werden. Dies resultiert darin, dass die Einhüllende des Ausgangssignals der Signalform des Modulationssignals besser folgt als bei einem Resonanzverstärker ohne Ansteuersignal. Verglichen mit dem Breitbandverstärker der DE 199 29 332 A1 wird eine vergleichbar gute Einhüllende erreicht, nur mit einer deutlich einfacheren Technik und deutlich kostengünstiger. Wenn das Modulationssignal ein Rechtecksignal, d.h. ein gepulstes Signal ist, wird eine steilflankige Hüllkurve des Ausgangssignals erreicht. Das Ansteuersignal kann beispielsweise dadurch erzeugt werden, dass beim erstmaligen Einschalten des oder der schaltenden Elemente des HF-Resonanzverstärkers die Einschaltdauer bewusst verlängert wird oder dass dem Ausgangsschwingkreis durch einen zusätzlichen Schalter eine höhere Spannung bzw. Leistung als im Normalbetrieb zugeführt wird.

Wenn in dem HF-Resonanzverstärker mehrere Schwingkreise vorhanden sind, können auch mehrere Schwingkreise mit dem von dem Grundsignal abweichenden Ansteuersignal angesteuert werden.

Insbesondere kann mit dem erfindungsgemäßen Verfahren das Ausschwingen eines gepulsten Grundsignals beschleunigt werden. Durch die Ansteuerung mit einem Ansteuersignal, das vom Grundsignal abweicht, wird die im Ausgangsschwingkreis gespeicherte Energie zumindest teilweise vernichtet, so dass der Ausschwingvorgang deutlich verkürzt wird. Somit kann bei einem Ausgangsschwingkreis mit hoher Güte die Dauer des Ausschwingvorgangs reduziert werden. Damit kann ein Ausgangsschwingkreis hoher Güte mit guter Filterwirkung verwendet werden, und somit ein Ausgangssignal mit großer spektraler Reinheit erzeugt werden.

Bei einer vorteilhaften Verfahrensvariante kann vorgesehen sein, dass der Ausgangsschwingkreis für eine vorgegebene oder vorgebbare Zeitdauer mit einem von dem Grundsignal wesentlich abweichenden Ansteuersignal angesteuert wird. Damit kann insbesondere das schnelle Ausschwingen optimiert werden.

Bei einer vorteilhaften Verfahrensvariante kann vorgesehen sein, dass der Zeitpunkt und die Zeitdauer derart gewählt werden, dass eine steilflankige Hüllkurve des Ausgangssignals entsteht. Dies kann insbesondere dadurch erreicht werden, dass das Ansteuersignal in Abhängigkeit von dem Modulationssignal erzeugt wird. Durch das Modulationssignal wird z.B. ein gepulstes Ausgangssignal des HF-Leistungsresonanzverstärkers erzeugt. Zu Beginn und Ende eines Pulses des Modulationssignals wird in der Regel auch eine steile Flanke der Hüllkurve des Ausgangssignals gefordert. Deshalb ist es vorteilhaft, wenn jedem Puls des Modulationssignals die Anregung des Ausgangsschwingkreises mit einem oder mehreren gezielt "falschen" Takten folgt.

Auf besonders einfache Art und Weise lässt sich das Ansteuersignal erzeugen, indem das Grundsignal verändert wird, insbesondere die Frequenz, die Phase und/oder das Tastverhältnis des Grundsignals verändert wird. Durch die Anregung des Ausgangsschwingkreises mit dem Grundsignal, d.h. mit der Grundfrequenz und der Grundphase, wird der Ausgangsschwingkreis in Resonanz betrieben. Wird der Ausgangsschwingkreis mit einem davon abweichenden Signal angeregt, wird die Schwingung des Ausgangsschwingkreises gebremst.

Bei einer weiteren Verfahrensvariante kann vorgesehen sein, dass das Ansteuersignal durch einen separaten Funktionsgenerator erzeugt wird, der den Ausgangsschwingkreis unmittelbar oder unter Zwischenschaltung eines Schalters, insbesondere Transistors, ansteuert. Durch einen Funktionsgenerator können nahezu beliebige Ansteuersignale erzeugt werden. Der Funktionsgenerator kann auch einen oder mehrere Verstärkertransistoren (schaltende Elemente) des HF-Leistungsresonanzverstärkers ansteuern. Ein derart angeordneter Funktionsgenerator kann einen Bremspuls erzeugen, wenn die Treiberstufe des HF-Resonanzverstärkers keine Signale mehr liefert, d.h. wenn das Modulationssignal eine Pulspause hat.

Zwischen Treiberstufe und schaltenden Elementen bzw. schaltendem Element kann ein Koppelkreis angeordnet sein. Dieser kann als Schwingkreis ausgebildet sein. Der Schwingkreis wird üblicherweise so gewählt, dass er seine Resonanzfrequenz im Bereich der Grundfrequenz hat, um die schaltenden Elemente des HF-Leistungsresonanzverstärkers mit ausreichend Strom und Spannung bei möglichst niedrigen Energieverlusten anzusteuern. Das vom Grundsignal abweichende Ansteuersignal lässt sich mit einem solchen Koppelkreis erzeugen, indem der Koppelkreis des HF-Resonanzverstärkers, dem das Grundsignal zugeführt wird, auf eine von der Grundfrequenz f_{T} abweichende Frequenz abgestimmt wird, etwa auf f₀ = f_{T}+ Δ. Dadurch läuft die Treiberstufe und somit auch der Koppelkreis stabil auf der Frequenz f_{T}, solange ein Puls des Modulationssignals anliegt. Sobald dieser endet, schwingt der Koppelkreis mit einigen abklingenden Perioden der Frequenz f₀ aus. Durch die Ansteuerung des schaltenden Elements und des Ausgangsschwingkreises mit dieser Frequenz, die gegenüber der Grundfrequenz f_{T} einen Phasenversatz aufbaut, entsteht das veränderte Ansteuersignal und somit ein oder mehrere Bremspulse.

Experimente haben ergeben, dass die besten Ergebnisse erzielt werden, wenn f₀ um 5% bis 20% von f_{T} abweicht insbesondere 5% bis 20% unter f_{T} liegt. Wenn f₀ ca. 10% unter f_{T} liegt, so sind nach fünf Perioden bei der Frequenz f₀ die Amplituden einer Schwingung bei f₀ und einer gedachten weiterlaufende f_{T} -Schwingung gegenphasig, und das Ausgangssignal hat keine nennenswerte Schwingung mehr (<0,1% vom Ausgangssignal im Normalbetrieb).

Vorzugsweise wird als Ansteuersignal ein Bremspuls erzeugt und wird der Ausgangsschwingkreis mit dem Bremspuls angesteuert. Durch Bremspulse, die dem Grundsignal überlagert sein können oder alternativ zum Grundsignal den Ausgangsschwingkreis ansteuern können, kann die im Ausgangsschwingkreis gespeicherte Energie vernichtet werden und so der Ausschwingvorgang deutlich verkürzt werden. Die maßgeschneiderten Bremspulse können von einem separaten Leistungstransistor erzeugt werden oder durch geeignete Ansteuerung des oder der ohnehin vorhandenen aktiven Elemente, insbesondere eines Verstärkertransistors oder von Verstärkertransistoren. Diese Ansteuerung kann ihrerseits wiederum entweder von einer separaten Funktionsgeneratorschaltung erzeugt werden oder, im einfachsten Fall, von der vorhandenen Treiberstufe durch einen Frequenzsprung der Treiberstufe beim Abschalten des Grundsignals zu Beginn der Pulspause des Modulationssignals.

Vorrichtungsmäßig betrifft die Erfindung eine HF-Anregungsanordnung mit einem HF-Leistungsresonanzverstärker, umfassend eine ein Grundsignal verstärkende Treiberstufe, zumindest ein aktives Element und zumindest einen diesem nachgeordneten Ausgangsschwingkreis, der auf eine Frequenz im Bereich der Grundfrequenz des Grundsignals abgestimmt ist, sowie mit einem Modulationssignalgenerator, der ein Modulationssignal zur Modulation des Grundsignals erzeugt, wobei eine Ansteuersignaleinrichtung vorgesehen ist, die ein von dem Grundsignal abweichendes Ansteuersignal für den Ausgangsschwingkreis erzeugt. Der Ausgangsschwingkreis ist in der Regel als Resonanzkreis ausgebildet, der im Wesentlichen auf eine Grundfrequenz abgestimmt ist. Die aktiven Elemente können Verstärkerstufen oder schaltende Elemente, insbesondere ein oder mehrere Transistoren, sein. Ein Resonanzverstärker kann z.B. ein Klasse E Verstärker sein. Dieser hat in der Regel einen einzigen im Schaltbetrieb arbeitenden Transistor. Es ist aber durchaus denkbar, einen Resonanzverstärker mit mehreren Transistoren zu betreiben und den oder die Transistoren auch im verstärkenden Betrieb arbeiten zu lassen. Ein Resonanzverstärker zeichnet sich dadurch aus, dass er mit einem oder mehreren Resonanzkreisen dafür sorgt, dass vorzugsweise die Grundwelle (Grundfrequenz des Grundsignals) zur Last weitergeleitet wird (die aktiven, insbesondere die schaltenden Elemente (Verstärkertransistoren) erzeugen noch eine Vielzahl von Oberwellen). Außerdem sorgt der Resonanzkreis dafür, dass die aktiven Elemente möglichst verlustarm betrieben werden. Dazu kann der Ausgangsschwingkreis auch leicht gegenüber der Grundfrequenz verstimmt sein. Wegen der Abstimmung im Wesentlichen auf die Grundfrequenz kann ein Resonanzverstärker nicht breitbandig arbeiten, wie dies im Stand der Technik vorgeschlagen wird. Mit der erfindungsgemäßen HF-Anregungsanordnung können die Anforderungen an einen HF-Verstärker erfüllt werden: hohe Güte, hohe spektrale Reinheit, gute Filterwirkung.

Die Erzeugung des Ansteuersignals kann in Abhängigkeit vom Modulationssignal erfolgen, wenn die Ansteuersignaleinrichtung mit dem Modulationssignalgenerator verbunden ist.

Ein Ansteuersignal in Form von einem oder mehreren Bremspulsen kann besonders einfach erzeugt werden, wenn die Ansteuersignaleinrichtung zumindest einen Schalter, insbesondere einen Leistungstransistor, umfasst.

Die Signalform des Ansteuersignals kann besonders einfach beeinflusst werden, wenn die Ansteuersignaleinrichtung zumindest einen Funktionsgenerator umfasst. Dabei kann der Funktionsgenerator unmittelbar mit dem Verstärkertransistor oder über einen oder mehrere Transistoren direkt mit den Ausgangsschwingkreis des HF-Leistungsresonanzverstärkers verbunden sein. Es können auch mehrere Funktionsgeneratoren verwendet werden.

Vorzugsweise ist das zumindest eine aktive Element des HF-Leistungsresonanzverstärkers für den Betrieb bis zu einer Frequenz im Bereich der Grundfrequenz ausgelegt. Insbesondere muss es nicht, wie im Stand der Technik, für höhere Frequenzen ausgelegt sein. Dadurch können kostengünstigere aktive Elemente als im Stand der Technik eingesetzt werden.

Als einfache technische Maßnahme zur Erzeugung eines Ansteuersignals kann als Ansteuersignaleinrichtung ein Koppelkreis zwischen die Treiberstufe und das zumindest eine aktive Element des HF-Leistungsresonanzverstärkers geschaltet sein, der auf eine von der Grundfrequenz abweichende Frequenz abgestimmt ist. Wie bereits oben erläutert, kann durch diese Maßnahme einfach ein Bremssignal erzeugt werden.

Besonders vorteilhaft kann die erfindungsgemäße HF-Anregungsanordnung und das erfindungsgemäße Verfahren für den Betrieb eines Güteschalters, insbesondere eines opto-akustischen Güteschalters, eingesetzt werden. Zur Ansteuerung eines derartigen Güteschalters werden gepulste Hochfrequenzsignale benötigt, die extrem kurze Ausschwingzeiten zu jedem Pulsende aufweisen.

Bevorzugte Ausführungsbeispiele der Erfindung sind in der Zeichnung schematisch dargestellt und werden nachfolgend mit Bezug zu den Figuren der Zeichnung näher erläutert. Dabei zeigen:
- Fig.1a: schematisch eine erste Ausführungsform einer HF-Anregungsanordnung;
- Fig. 1b: stark schematisiert eine zweite Ausführungsform einer HF-Anregungsanordnung mit einer ein schaltendes Element des HF-Leistungsresonanzverstärkers ansteuernden Ansteuersignaleinrichtung;
- Fig. 1c: eine dritte Ausführungsform einer HF-Anregungsanordnung mit zwischen einer Treiberstufe und einem schaltenden Element angeordneter Ansteuersignaleinrichtung;
- Fig. 1d: eine vierte Ausführungsform einer HF-Anregungsanordnung mit in einer Treiberstufe angeordneter Ansteuersignaleinrichtung;
- Fig. 1e: eine fünfte Ausführungsform einer HF-Anregungsanordnung mit in einem Oszillator angeordneter Ansteuersignaleinrichtung;
- Fig. 2a: ein Modulationssignal;
- Fig. 2b: eine schematische Darstellung des mit dem Modulationssignal amplitudenmodulierten Grundsignals, an das sich ein Ansteuersignal anschließt;
- Fig. 2c: eine schematische Darstellung des HF-Ausgangssignals, wie es ohne Ansteuersignal nach dem Stand der Technik entstehen würde;
- Fig. 2d: eine schematische Darstellung des mit dem Modulationssignal amplitudenmodulierten Grundsignals mit sich anschließendem erfindungsgemäßem Ansteuersignal ;
- Fig. 2e: eine schematische Darstellung des HF-Ausgangssignals, wie es erfindungsgemäß mit Ansteuersignal entsteht.

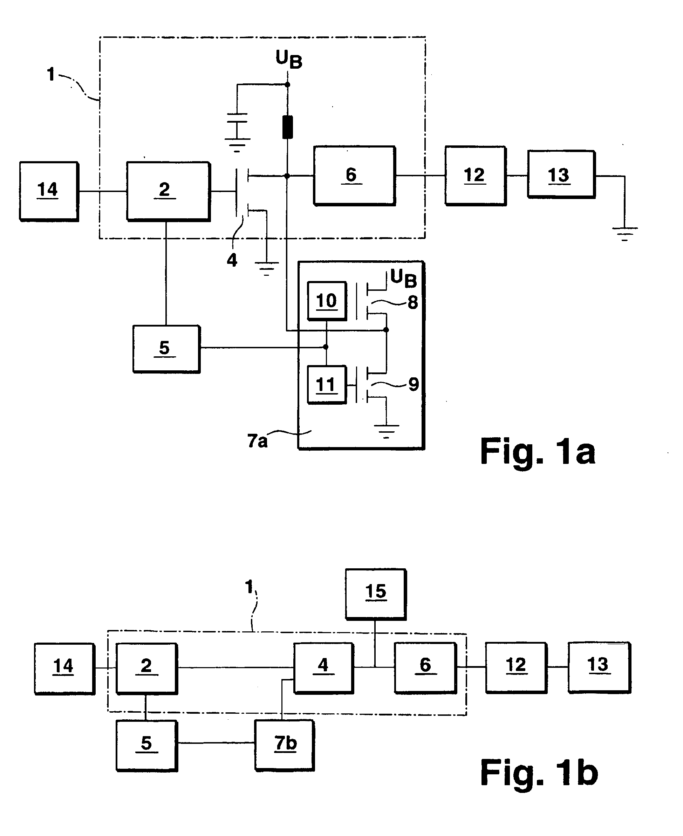

In der Fig. 1a ist eine HF-Anregungsanordnung mit einem HF-Leistungsresonanzverstärker 1 gezeigt, der eine Treiberstufe 2 umfasst, die ein schaltendes Element 4 ansteuert. Die Treiberstufe 2 ist mit einem Oszillator 14 verbunden. Der Oszillator 14 liefert ein als Grundsignal bezeichnetes hochfrequentes Signal, das die Treiberstufe 2 verstärkt und damit das schaltende Element 4 ansteuert. Die Treiberstufe 2 wird durch einen Modulationssignalgenerator 5 mit einem Modulationssignal angesteuert. Dabei weist das Modulationssignal eine geringere Frequenz auf als das Grundsignal. Beispielsweise hat das Grundsignal eine Frequenz f_{T} = 27,12MHz und das Modulationssignal eine Frequenz f₂ = 100kHz. Dabei kann das Modulationssignal pulsförmig, insbesondere rechteckförmig, sein und ein beliebiges Tastverhältnis besitzen.

Am Ausgang eines Ausgangsschwingkreises 6 und damit am Ausgang des HF-Leistungsresonanzverstärkers 1 liegt ein verstärktes hochfrequentes Signal an. Bei diesem Signal handelt es sich um das mit dem Modulationssignal modulierte verstärkte Grundsignal. Der Ausgangsschwingkreis 6 ist auf eine Frequenz im Bereich der Grundfrequenz des Grundsignals abgestimmt. In der Regel wird als Modulationssignal ein rechteckförmiges Signal mit vorgegebenem Puls-Pausenverhältnis verwendet. Dies bedeutet, dass das Ausgangssignal des HF-Leistungsresonanzverstärkers 1 ein gepulstes HF-Signal ist. Während einer Pulspause des Modulationssignals sollte das Ausgangssignal schnell ausschwingen. Wird der Ausgangsschwingkreis 6 aufgrund einer Pulspause des Modulationssignals jedoch durch die Treiberstufe 2 vorübergehend nicht angeregt, so schwingt der Ausgangsschwingkreis 6 nach. Um dieses Nachschwingen beziehungsweise Ausschwingen möglichst gering zu halten, wird erfindungsgemäß der Ausgangsschwingkreis 6 mit einem Ansteuersignal angesteuert, welches von dem Grundsignal verschieden ist. Hierzu sind mehrere Möglichkeiten denkbar. Im in der Fig. 1a gezeigten Ausführungsbeispiel ist eine Ansteuersignaleinrichtung 7a vorgesehen, die zwei als Transistoren ausgebildete Schalter 8, 9 aufweist, die jeweils mit einem Funktionsgenerator 10, 11 angesteuert sind. Damit das Ansteuersignal zum richtigen Zeitpunkt und in der richtigen Länge an den Ausgangsschwingkreis 6 gegeben wird, sind die Funktionsgeneratoren 10, 11 und damit die Ansteuersignaleinrichtung 7a mit dem Modulationssignalgenerator 5 verbunden, so dass in Abhängigkeit vom Modulationssignal das Ansteuersignal generiert werden kann. Die Ausgangsleistung des HF-Leistungsresonanzverstärkers kann über die Versorgungsspannung U_{B} eingestellt werden. Die Ansteuersignaleinrichtung 7a kann ebenfalls von U_{B} versorgt werden, wie in der Fig. 1a gezeigt, sie kann aber auch von einer unabhängigen Spannungs- oder Stromquelle versorgt werden.

Dem HF-Leistungsresonanzverstärker 1 kann ein Impedanzanpassungsglied 12 nachgeschaltet sein, das somit zwischen dem Ausgangsschwingkreis 6 und einer Last 13 liegt, die als Güteschalter ausgebildet sein kann und durch das Ausgangssignal betrieben werden kann. Auch das Impedanzanpassungsglied 12 und die Last 13 können schwingfähig sei und somit eine Resonanzfrequenz aufweisen. Beispielsweise besitzt ein Quarz-Güteschalter eine Resonanzfrequenz. Das Ausschwingverhalten des Ausgangsschwingkreises 6 kann somit von den nachgeschalteten Elementen abhängen. Sind die Resonanzfrequenzen beispielsweise des Impedanzanpassungsglieds 12 und/oder der Last 13 bekannt, können diese bei der Erzeugung des Ansteuersignals derart berücksichtigt werden, dass das Ausschwingen des dem schaltenden Element 4 nachgeschalteten Schwingungssystems bei fehlender Anregung durch das Grundsignal beschleunigt wird.

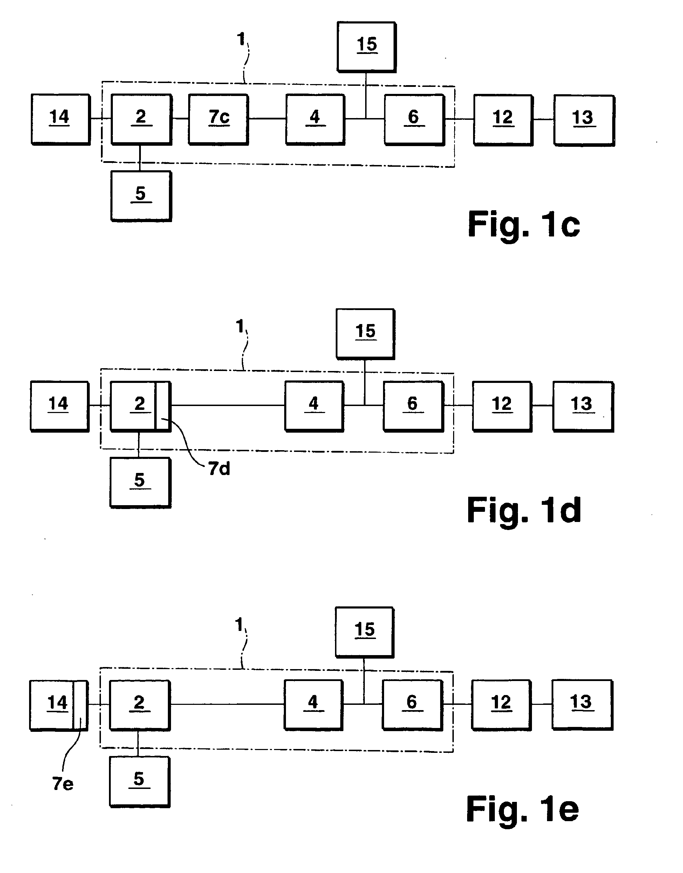

Im Folgenden werden für sich entsprechende Bauteile die gleichen Bezugsziffern verwendet. In der Fig. 1b ist im Unterschied zur Fig. 1 die Ansteuersignaleinheit 7b mit dem schaltenden Element 4 verbunden. Mit der Bezugsziffer 15 ist eine externe Gleichstromversorgung angedeutet.

In der Fig. 1c wird das Ansteuersignal mit der als Koppelkreis ausgebildeten Ansteuersignaleinheit 7c erzeugt, indem der Koppelkreis auf eine von der Grundfrequenz f_{T} abweichende Frequenz f₀ = f_{T}+ Δ abgestimmt ist. Dadurch läuft die Treiberstufe 2 und somit auch der Koppelkreis stabil auf der Frequenz f_{T}, solange ein positiver Pegel des Modulationssignals anliegt. Sobald dieser endet, schwingt der Koppelkreis mit einigen abklingenden Perioden der Frequenz f₀ aus. Durch die Ansteuerung des schaltenden Elements 4 und des Ausgangsschwingkreises 6 mit dieser Frequenz, die gegenüber der Grundfrequenz f_{T} einen Phasenversatz aufbaut, entsteht das Ansteuersignal.

Gemäß der Fig. 1e ist die Treiberstufe 2 als Ansteuersignaleinheit ausgebildet bzw. weist die Treiberstufe 2 eine Ansteuersignaleinheit 7d auf. Das Ansteuersignal wird also generiert, indem das Grundsignal in der Treiberstufe 2 bzw. in der Ansteuersignaleinheit 7d verändert wird.

Eine weitere Möglichkeit der Erzeugung des Ansteuersignals ist in der Fig. 1e dargestellt. Hier stellt der Oszillator 14 die Ansteuersignaleinheit dar bzw. weist der Oszillator 14 eine Ansteuersignaleinheit 7e auf. Dies bedeutet, dass das Ansteuersignal erzeugt wird, indem das Grundsignal im Oszillator 14 bzw. in der darin enthaltenen Ansteuersignaleinheit 7e verändert wird. Dabei kann der Oszillator z.B. aus einem Quarzoszillator oder vergleichbaren frequenzstabilen oszillierendem Gebilde und einer externen Logik, z.B. einem programmierbaren Logikbaustein (CPLD) bestehen. Das Modulationssignal würde dann auch dem Oszillator zugeordnet werden.

In den Fign. 1a - 1e wurden die Elemente 5, 7a, 7b, 12, 14, 15 außerhalb des HF-Leistungsresonanzverstärkers 1 dargestellt. Diese Elemente können jedoch auch Teile des HF-Leistungsresonanzverstärkers 1 sein.

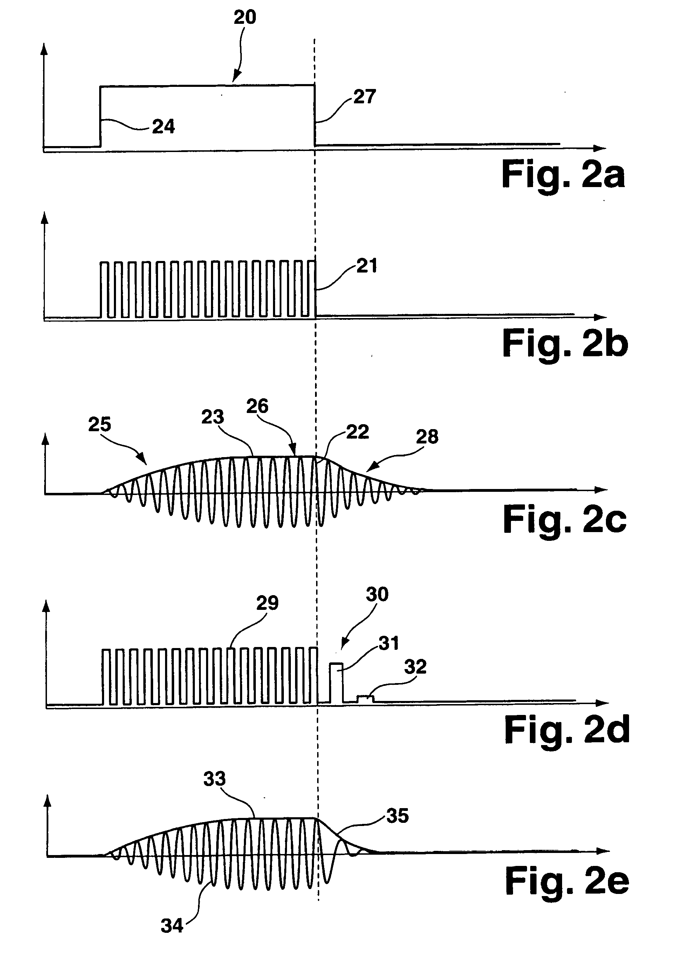

Die Figuren 2a bis 2e stellen schematische Darstellungen von Signalen dar, die nicht maßstabsgetreu sein müssen, sondern das Funktionsprinzip verdeutlichen sollen. In der Fig. 2a ist beispielhaft ein Modulationssignal 20 dargestellt, wie es durch den Modulationssignalgenerator 5 erzeugt werden kann. Dargestellt ist ein Rechtecksignal. Die Signalform des Modulationssignals 20 gibt die gewünschte Signalform der Einhüllenden des Ausgangssignals des Ausgangsschwingkreises wieder.

In der Fig. 2b ist das Grundsignal amplitudenmoduliert mit dem Modulationssignal 20 gemäß dem Stand der Technik dargestellt. Dies bedeutet, dass der Ausgangsschwingkreis 6 mit einem hochfrequenten Eingangssignal gespeist wird, solange das Modulationssignal 20 einen positiven Signalpegel hat.

Die Fig. 2c zeigt ein Ausgangssignal 22 des Ausgangsschwingkreises 6, wenn gemäß dem Stand der Technik kein vom Grundsignal abweichendes Ansteuersignal angelegt werden würde. Weiterhin ist eine Einhüllende 23 dieses Signals dargestellt. Es ist zu erkennen, dass die Einhüllende 23 der steigenden Flanke 24 des Modulationssignals 20 im Bereich 25 nur allmählich folgt, solange der Ausgangsschwingkreises 6 anschwingt. Nach einer gewissen Zeit, im Bereich 26, bildet die Einhüllende 23 das Modulationssignal 20 relativ gut nach. Nach einer fallenden Flanke 27 des Modulationssignals 20 schwingt der Ausgangsschwingkreis 6 allmählich aus, was in einer flachen Flanke 28 des Ausgangssignals 22 resultiert.

In der Fig. 2d ist das mit dem Modulationssignal amplitudenmodulierte Grundsignal 29 mit sich anschließendem erfindungsgemäßem Ansteuersignal 30 dargestellt. Nach der fallenden Flanke 27 des Modulationssignals 20 hört das Signal 29 nicht abrupt auf, sondern wird ein Ansteuersignal 30 erzeugt, welches im Ausführungsbeispiel zwei Bremspulse 31, 32 aufweist. Die Ansteuerung des Ausgangsschwingkreises 6 mit dem Ansteuersignal 30 resultiert in einem schnelleren Ausschwingen des Ausgangsschwingkreises 6, so dass die Einhüllende 33 des in der Fig. 2e gezeigten Ausgangssignals 34 eine steile Flanke 35 aufweist.

## Patentansprüche

1. Verfahren zur Beschleunigung des Ausschwingens eines Ausgangsschwingkreises (6) eines HF-Leistungsresonanzverstärkers (1), bei dem ein Grundsignal einer Grundfrequenz verstärkt und mit einem Modulationssignal (20) moduliert, wird, **dadurch gekennzeichnet, dass** der Ausgangsschwingkreis (6) des HF-Leistungsresonanzverstärkers auf eine Frequenz im Bereich der Grundfrequenz abgestimmt wird und im Normalbetrieb mit dem Grundsignal angeregt wird, ein Ansteuersignal (30) generiert wird und zu vorgegebenen oder vorgebbaren Zeitpunkten der Ausgangsschwingkreis (6) mit dem von dem Grundsignal abweichenden Ansteuersignal (30) angeregt wird.

2. Verfahren nach Anspruch 1, **dadurch gekennzeichnet, dass** der Ausgangsschwingkreis (6) für eine vorgegebene oder vorgebbare Zeitdauer mit dem Ansteuersignal (30) angesteuert wird.

3. Verfahren nach einem der vorhergehenden Ansprüche, **dadurch gekennzeichnet, dass** der Zeitpunkt und/oder die Zeitdauer derart gewählt werden, dass eine zumindest an der fallenden Flanke steilflankige Einhüllende (33) des Ausgangssignals (34) entsteht.

4. Verfahren nach einem der vorhergehenden Ansprüche, **dadurch gekennzeichnet, dass** das Ansteuersignal (30) in Abhängigkeit von dem Modulationssignal (20) erzeugt wird.

5. Verfahren nach einem der vorhergehenden Ansprüche, **dadurch gekennzeichnet, dass** das Ansteuersignal (30) erzeugt wird, indem das Grundsignal verändert wird, insbesondere die Frequenz, die Phase und/oder das Tastverhältnis des Grundsignals verändert wird.

6. Verfahren nach einem der vorhergehenden Ansprüche, **dadurch gekennzeichnet, dass** das Ansteuersignal (30) durch einen separaten Funktionsgenerator (10, 11) erzeugt wird, der den Ausgangsschwingkreis (6) unmittelbar oder unter Zwischenschaltung eines Schalters (8, 9), insbesondere Transistors, ansteuert.

7. Verfahren nach einem der vorhergehenden Ansprüche, **dadurch gekennzeichnet, dass** ein Koppelkreis des HF-Leistungsresonanzverstärkers (1), dem das Grundsignal zugeführt wird, auf eine von der Grundfrequenz abweichende Frequenz abgestimmt wird.

8. Verfahren nach einem der vorhergehenden Ansprüche, **dadurch gekennzeichnet, dass** als Ansteuersignal (30) ein Bremspuls (31, 32) erzeugt wird und der Ausgangsschwingkreis (6) mit dem Bremspuls (31, 32) angesteuert wird.

9. HF-Anregungsanordnung, insbesondere zur Durchführung des Verfahrens nach einem der vorhergehenden Ansprüche, mit einem HF-Leistungsresonanzverstärker (1), umfassend eine ein Grundsignal verstärkende Treiberstufe (2), zumindest ein aktives Element (4) und zumindest einen diesem nachgeordneten Ausgangsschwingkreis (6), der auf eine Frequenz im Bereich der Grundfrequenz des Grundsignals abgestimmt ist, und mit einem Modulationssignalgenerator (5), der ein Modulationssignal (20) zur Modulation des Grundsignals erzeugt, **dadurch gekennzeichnet, dass** eine Ansteuersignaleinrichtung (7a) vorgesehen ist, die ein von dem Grundsignal abweichendes Ansteuersignal (30) für den Ausgangsschwingkreis (6) erzeugt.

10. HF-Anregungsanordnung nach Anspruch 9, **dadurch gekennzeichnet, dass** die Ansteuersignaleinrichtung (7a, 7b) mit dem Modulationssignalgenerator (5) verbunden ist.

11. HF-Anregungsanordnung nach Anspruch 9 oder 10, **dadurch gekennzeichnet, dass** die Ansteuersignaleinrichtung (7a) zumindest einen Schalter (8, 9), insbesondere einen Leistungstransistor, umfasst.

12. HF-Anregungsanordnung nach einem der Ansprüche 9 bis 11, **dadurch gekennzeichnet, dass** die Ansteuersignaleinrichtung (7a) zumindest einen Funktionsgenerator (10, 11) umfasst.

13. HF-Anregungsanordnung nach einem der vorhergehenden Ansprüche 9 bis 12, **dadurch gekennzeichnet, dass** das zumindest eine aktive Element (4) des HF- Leistungsresonanzverstärkers (1) für den Betrieb bis zu einer Frequenz im Bereich der Grundfrequenz ausgelegt ist.

14. HF-Anregungsanordnung nach einem der vorhergehenden Ansprüche 9 bis 13, **dadurch gekennzeichnet, dass** als Ansteuereinrichtung (7c) ein Koppelkreis zwischen die Treiberstufe (2) und das zumindest eine aktive Element (4) des HF-Leistungsresonanzverstärkers geschaltet ist, der auf eine von der Grundfrequenz abweichende Frequenz abgestimmt ist.

15. Verwendung einer HF-Anregungsanordnung nach einem der vorhergehenden Ansprüche 9 bis 14, für den Betrieb eines Güteschalters, insbesondere opto-akustischen Güteschalters.

## Claims

1. Method for accelerating the dying down of an output oscillator circuit (6) of a HF power resonance amplifier (1), in which a basic signal of a basic frequency is amplified and modulated with a modulation signal (20), **characterised in that** the output oscillator circuit (6) of the HF power resonance amplifier is tuned to a frequency in the range of the basic frequency and is excited with the basic signal in normal operation, a control signal (30) is generated, and the output oscillator circuit (6) is excited at predetermined or predeterminable points in time with the control signal (30) that differs from the basic signal.

2. Method according to claim 1, **characterised in that** the output oscillator circuit (6) is controlled with the control signal (30) for a predetermined or predeterminable period of time.

3. Method according to any one of the preceding claims, **characterised in that** the point in time and/or the period of time are so chosen that an envelope (33) of the output signal (34) that has a steep slope at least at the falling edge is formed.

4. Method according to any one of the preceding claims, **characterised in that** the control signal (30) is generated in dependence on the modulation signal (20).

5. Method according to any one of the preceding claims, **characterised in that** the control signal (30) is generated by changing the basic signal, in particular by changing the frequency, the phase and/or the duty cycle of the basic signal.

6. Method according to any one of the preceding claims, **characterised in that** the control signal (30) is generated by a separate function generator (10, 11) which controls the output oscillator circuit (6) directly or with the interposition of a switch (8, 9), in particular a transistor.

7. Method according to any one of the preceding claims, **characterised in that** a coupling circuit of the HF power resonance amplifier (1) to which the basic signal is supplied is tuned to a frequency differing from the basic frequency.

8. Method according to any one of the preceding claims, **characterised in that** a braking pulse (31, 32) is generated as the control signal (30) and the output oscillator circuit (6) is controlled with the braking pulse (31, 32).

9. HF excitation arrangement, in particular for carrying out the method according to any one of the preceding claims, having a HF power resonance amplifier (1), comprising a driver stage (2) which amplifies a basic signal, at least one active element (4) and at least one output oscillator circuit (6) which is arranged downstream thereof and is tuned to a frequency in the range of the basic frequency of the basic signal, and having a modulation signal generator (5) which generates a modulation signal (20) for modulating the basic signal, **characterised in that** there is provided a control signal device (7a) which generates a control signal (30) for the output oscillator circuit (6) that differs from the basic signal.

10. HF excitation arrangement according to claim 9, **characterised in that** the control signal device (7a, 7b) is connected to the modulation signal generator (5).

11. HF excitation arrangement according to claim 9 or 10, **characterised in that** the control signal device (7a) comprises at least one switch (8, 9), in particular a power transistor.

12. HF excitation arrangement according to any one of claims 9 to 11, **characterised in that** the control signal device (7a) comprises at least one function generator (10, 11).

13. HF excitation arrangement according to any one of the preceding claims 9 to 12, **characterised in that** the at least one active element (4) of the HF power resonance amplifier (1) is designed for operation up to a frequency in the range of the basic frequency.

14. HF excitation arrangement according to any one of the preceding claims 9 to 13, **characterised in that**, as a control device (7c), a coupling circuit is connected between the driver stage (2) and the at least one active element (4) of the HF power resonance amplifier, which coupling circuit is tuned to a frequency that differs from the basic frequency.

15. Use of an HF excitation arrangement according to any one of the preceding claims 9 to 14 for the operation of a Q-switch, in particular an opto-acoustic Q-switch.

## Revendications

1. Procédé pour accélérer l'amortissement d'un circuit oscillant de sortie (6) d'un amplificateur de résonance de puissance HF (1), dans lequel un signal de base d'une fréquence de base est amplifié et modulé avec un signal de modulation (20), **caractérisé en ce que** le circuit oscillant de sortie (6) de l'amplificateur de résonance de puissance HF est accordé sur une fréquence dans la gamme de la fréquence de base et, en fonctionnement normal, excité par le signal de base, un signal d'activation (30) est généré et, à des instants prédéfinis ou prédéfinissables, le circuit oscillant de sortie (6) est excité par le signal d'activation (30) différent du signal de base.

2. Procédé selon la revendication 1, **caractérisé en ce que** le circuit oscillant de sortie (6) est activé par le signal d'activation (30) pendant une durée prédéfinie ou prédéfinissable.

3. Procédé selon une des revendications précédentes, **caractérisé en ce que** l'instant et/ou la durée sont choisis de façon à produire une enveloppante (33) du signal de sortie (34) à flanc raide au moins sur le flanc descendant.

4. Procédé selon une des revendications précédentes, **caractérisé en ce que** le signal d'activation (30) est généré en fonction du signal de modulation (20).

5. Procédé selon une des revendications précédentes, **caractérisé en ce que** le signal d'activation (30) est généré en modifiant le signal de base, en particulier la fréquence, la phase et/ou le rapport cyclique du signal de base.

6. Procédé selon une des revendications précédentes, **caractérisé en ce que** le signal d'activation (30) est généré par un générateur de fonctions (10, 11) séparé qui active le circuit oscillant de sortie (6) directement ou par l'intermédiaire d'un commutateur (8, 9), en particulier d'un transistor.

7. Procédé selon une des revendications précédentes, **caractérisé en ce qu'**un circuit de couplage de l'amplificateur de résonance de puissance HF (1), auquel le signal de base est amené, est accordé sur une fréquence différente de la fréquence de base.

8. Procédé selon une des revendications précédentes, **caractérisé en ce qu'**une impulsion de freinage (31, 32) est générée en tant que signal d'activation (30) et le circuit oscillant de sortie (6) est activé par l'impulsion de freinage (31, 32).

9. Dispositif d'excitation HF, en particulier pour réaliser le procédé selon une des revendications précédentes, avec un amplificateur de résonance de puissance HF (1), comprenant un étage d'attaque (2) qui amplifie un signal de base, au moins un élément actif (4) et au moins un circuit oscillant de sortie (6) en aval de celui-ci, qui est accordé sur une fréquence dans la gamme de la fréquence de base du signal de base, et avec un générateur de signaux de modulation (5) qui génère un signal de modulation (20) pour moduler le signal de base, **caractérisé en ce qu'**un moyen de signalisation d'activation (7a) est prévu, qui génère un signal d'activation (30) différent du signal de base pour le circuit oscillant de sortie (6).

10. Dispositif d'excitation HF selon la revendication 9, **caractérisé en ce que** le moyen de signalisation d'activation (7a, 7b) est relié au générateur de signaux de modulation (5).

11. Dispositif d'excitation HF selon la revendication 9 ou 10, **caractérisé en ce que** le moyen de signalisation d'activation (7a) comprend au moins un commutateur (8, 9), en particulier un transistor de puissance.

12. Dispositif d'excitation HF selon une des revendications 9 à 11, **caractérisé en ce que** le moyen de signalisation d'activation (7a) comprend au moins un générateur de fonctions (10, 11).

13. Dispositif d'excitation HF selon une des revendications précédentes 9 à 12, **caractérisé en ce que** ledit au moins un élément actif (4) de l'amplificateur de résonance de puissance HF (1) est conçu pour fonctionner jusqu'à une fréquence dans la gamme de la fréquence de base.

14. Dispositif d'excitation HF selon une des revendications précédentes 9 à 13, **caractérisé en ce qu'**un circuit de couplage est branché en tant que moyen d'activation (7c) entre l'étage d'attaque (2) et ledit au moins un élément actif (4) de l'amplificateur de résonance de puissance HF, lequel est accordé sur une fréquence différente de la fréquence de base.

15. Utilisation d'un dispositif d'excitation HF selon une des revendications précédentes 9 à 14 pour le fonctionnement d'un commutateur de facteur de qualité, en particulier d'un commutateur de facteur de qualité opio-acoustique.
